(19) Europäisches Patentamt
European Patent Office
Office européen des brevets

(11) Publication number: 0 342 840 A2

(12) # EUROPEAN PATENT APPLICATION

(21) Application number: 89304652.4

(22) Date of filing: 09.05.89

(51) Int. Cl.4: C08G 18/67 , C08G 18/83 , C08F 283/00 , H05K 3/34 , G03C 1/68 , B23K 35/22

(30) Priority: 17.05.88 US 195059

(43) Date of publication of application: 23.11.89 Bulletin 89/47

(84) Designated Contracting States: AT BE CH DE FR GB IT LI LU NL SE

(71) Applicant: M & T CHEMICALS, INC.
One Woodbridge Center
Woodbridge, New Jersey 07095(US)

(72) Inventor: Hung, Paul Ling Kong
428 Durham Avenue
Edison, N.J. 08872(US)
Inventor: Tseng, Kenneth
19 Traci Lane
Edison, N.J. 08872(US)

(74) Representative: Paget, Hugh Charles Edward et al
MEWBURN ELLIS & CO. 2/3 Cursitor Street
London EC4A 1BQ(GB)

(54) **Urethane acrylate compounds and solder masks.**

(57) Urethane acrylate oligomeric compounds are described having a terminal alkyl acrylate group and at least one terminal carboxylic acid group. An alkylene polyol residue , e.g. of glycerol, links the carboxylic acid group-(preferably derived from maleic anhydride) to two urethane linkages between two diisocyanate residues, and a polyol e.g.ethylene glycol, residue. The compounds may be formulatedinto solvent free, 100% solids solder mask compositions forprinted circuit boards, which compositions are UV curable and developable using aqueous alkaline solvents.

EP 0 342 840 A2

## URETHANE ACRYLATE COMPOUNDS AND SOLDER MASKS

This invention relates to urethane acrylate oligomeric compounds, solvent-free liquid solder mask compositions containing them, and processes for solder mask imaging using them.

An article in "Circuits Manufacturing", pages 24-33 (January, 1987) describes recent commercial advances in the art of photoimageable liquid solder masks, which are intended to provide technical and cost advantages over traditional dry film solder masks.

A number of U.S. patents disclose photopolymerizable oligomers and compositions for use as solder masks in printed circuit boards, including U.S. 3,660,088; 3,753,720; 3,883,352; 3,887,450; 4,199,163; 4,228,232; 4,304,923; 4,361,640; 4,436,806; 4,458,007; 4,481,281; and 4,508,916. However, none of those UV curable compounds and compositions is entirely satisfactory for use as a commercial solder mask, particularly for a screen-printable, photoimageable, 100% solids, solvent-free, liquid solder mask, which exhibits advantageous performance characteristics, and is aqueous alkaline developable.

Rousseau, in U.S. Patent 4,228,232, describes an oligomer and composition for use in a presensitized plate for printing operations, such as is used in the formation of lithographic plates. For such application, the oligomers must be tough but do not require flexibility, heat, chemical and electrical insulation resistance, high photoresponse, screen printability, adhesion to substrate, nor other properties useful for solder mask operation. Accordingly, Rousseau's oligomer has a high molecular weight polymeric backbone derived from an aromatic diisocyanate and polymeric polyols, e.g. polyester and polyalkylene polyols, which have molecular weights up to 10,000, and high hydroxy equivalent weights of 45 to 5,000, most preferably 200 to 2,000. The compositions formulated by Rousseau require an organic solvent to dissolve the oligomers and render formulation in a viscosity range useful for practical applications.

Rendulic, in U.S. Patent 4,436,806 describes a method and apparatus for making a printed circuit board by imaging a liquid polymer which has been coated onto the board by roller coating. In this process, imaging is carried out while the polymer is wet and the phototool is positioned in close proximity to the coated board. The liquid polymer compositions disclosed by Rendulic for use in this process are urethane acrylates having a polyether or polyester polyol chain extending unit. Such compositions have a very low viscosity, which is desirable for forming coatings with a roller coater. However, these compositions have a relatively low degree of ethylenic unsaturation per weight unit so that they require a relatively high energy level for curing.

In contrast to the imaging technique of the above mentioned patent, Sullivan, in U.S. Patent 4,506,004, describes a contact method of imaging: a liquid solder mask coating is screen printed to a given thickness, prehardened and imaged by exposure with suitable UV energy. The desired characteristics of excellent product performance and printing resolution are the attributes of the Sullivan system. The requirements of a suitable liquid photopolymerizable compound for use in this process include an ability to form a smooth, flexible coating which can impart chemical, electrical insulation and heat resistance to the solder mask. Furthermore, the coating must exhibit excellent adhesion to the printed circuit board with different types of metallization, and an ability to be cured to a desired depth with a minimum amount of UV energy.

In one aspect, the present invention seeks to provide new compounds useful in making solder mask coatings. In another aspect, solder mask compositions containing the new compounds are provided. It is particularly preferred that these compositions be developable with aqueous solutions, to avoid the use of organic solvents in the developing step.

Within the scope of this application, various preferred problems are also addressed. These include:

to provide a liquid UV curable urethane acrylate compound, and a 100% solids, solvent-free composition for use as a solder mask, which composition can be developed rapidly in an aqueous, slightly alkaline solution, preferably at a rate of at least 1 mil/min., at temperature of less than 39°C. and at a pH of 10-11, without leaving a residue;

to provide a UV curable urethane acrylate compound and composition having a suitable viscosity which enables coating by screen printing techniques to form a smooth, uniform, glossy, flexible coating of a thickness of 1 mil or more;

to provide such a solder mask coating which can be cured, preferably at an energy level of less than 0.5 joules per sq. cm., to provide a cure depth of at least 18 mils at this energy level;

to provide a solder mask composition which is stable without gelation for at least six months, under ambient storage conditions;

to provide a flexible solder mask coating having excellent adhesion to the underlying metal of the printed circuit board, particularly on copper and tin-lead;

to provide a solder mask coating which exhibits good surface hardness, abrasion, heat, organic solvent and

electrical insulation (IPC Class III) resistance ;

to provide a composition which is particularly adapted for use in the method and apparatus of making printed circuit boards as described in U.S. Patent 4,506,004 ; and

A further object of the invention is to provide a UV curable urethane acrylate compound and composition which meets acceptable environmental standards.

In one aspect, the present invention provides a solution by proposing a liquid, UV curable, aqueous alkaline developable urethane acrylate compound for formulation into a composition useful in making a solder mask coating. The urethane acrylate compound of this aspect is obtainable by reacting:

(i) two moles of a diisocyanate, e.g. an aliphatic, cycloaliphatic, aromatic diisocyanate, or aromatic-aliphatic diisocyanate, or mixtures thereof, e.g. dicyclohexylmethylene diisocyanate, isophorone diisocyanate, hexamethylene diisocyanate, toluene diisocyanate and phenyldialkylene diisocyanate;

(ii) one mole of a hydroxyalkyl acrylate or a hydroxy extended-alkyl acrylate; e.g. hydroxypropyl acrylate or a caprolactone acrylate monomer;

(iii) one mole of a polyol; e.g. ethylene glycol;

(iv) one mole of a simple alkylene polyol compound having 3-6 hydroxyl groups and 3-6 carbon atoms; e.g. glycerol; and

(v) at least a half mole of a dicarboxylic acid or anhydride, saturated or unsaturated; e.g. maleic anhydride.

In another aspect, the desired urethane acrylate oligomer is characterized by the following chemical constituents:

(a) terminal ethylenic unsaturation;

(b) at least one terminal carboxylic acid group;

(c) two intermediate urethane groups;

(d) a group derived from a polyol with two hydrogen atoms removed connecting the urethane groups; and

(e) a simple alkylene group derived from a simple alkylene polyol with at least two hydrogen atoms removed connecting one of the urethane groups and the terminal carboxylic acid group.

In another aspect, the invention provides urethane acrylate compounds of the formula:

$$[CH_2{=}\,CH-\overset{\overset{O}{\|}}{C}-O(CH_2)_n-O-X_a-\overset{\overset{O}{\|}}{C}-NH-R_1-NH-\overset{\overset{O}{\|}}{C}-O-Y-O\overset{\overset{O}{\|}}{C}-NH-R_1'\ NH\overset{\overset{O}{\|}}{C}-$$

$$-OCH_2]_m R_2(OH)_p(O\overset{\overset{O}{\|}}{C}R_3COOH)_z$$

where:

n is 1-8;

x is derived from a caprolactone, caprolactam, or epoxide;

a is 0 or 1;

$R_1$ and $R_1'$ are independently aliphatic, cycloaliphatic, aromatic or aromatic-aliphatic;

Y is the residue of a polyol with two hydroxyl groups removed;

m is 1-3;

$R_2$ is alkylene, $C_1$-$C_6$, however if $m = 1$, then $R_2$ is alkylene $C_2$-$C_6$;

p is 0-4;

$R_3$ is aliphatic or cycloaliphatic, saturated or unsaturated, or aromatic, and

z is 1-3.

The preferred individual values are: n is 2-3;

X is $\{\overset{\overset{O}{\|}}{C}(CH_2)_5-O\}_b$ where b is 1-10;

$\{\overset{\overset{O}{\|}}{C}(CH_2)_5-NH\}_c$ where c is 1-10; or

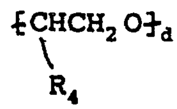

where d is 2-20 and $R_4$ is H, or alkyl or cycloalkyl with from one to six carbon atoms.
a is 1;
$R_1$ and $R'_1$ are selected from dicyclohexylmethylene or phenyl diisopropylene diisocyanate;
Y is alkylene;
m is 1 or 2;
$R_2$ is derived from glycerol;
p is 0 or 1;
$R_3$ is derived from maleic anhydride;
z is 1; and
$3 \leq m + p + z \leq 6$.

In another aspect, there are provided 100% solids, solvent-free UV curable, aqueous alkaline developable urethane acrylate solder mask compositions comprising;

(a) 20-60% by weight of the above-described urethane acrylate compound,
(b) 10-40% by weight of aromatic urethane diacrylates;
(c) 10-30% by weight of aliphatic and/or cycloaliphatic urethane diacrylates;
(d) 10-40% by weight of one or more reactive monomer diluents; and
(e) 0.5-10% by weight of a photoinitiator.

The composition of this aspect may also include one or more of the following optional constituents: a cross-linking agent, a pigment or dye, a rheology modifier, a thermal stabilizer, a filler, an adhesion promotor, a flame retardant and/or a leveling aid, in amounts of about 0.1-15% of each.

Physically, the urethane acrylate compound may be characterized by having a viscosity amenable to formulation into a 100% solids, solvent-free composition which is screen printable onto a printed circuit board to form a useful liquid solder mask, a level of volatility which conforms to acceptable standards, and where otherwise enables the preparation of a high-performance liquid solder mask.

A problem which may thus be solved is the provision of a printed circuit board having a liquid solder mask thereon as a smooth, glossy, flexible coating, which can be cured at low energy levels to provide a high cure depth, excellent surface hardness, and abrasion, heat, organic solvent and electrical insulation resistance (IPC Class III). The coating may be developed rapidly in an aqueous, slightly alkaline medium at ambient temperature.

UV curable, aqueous alkaline developable urethane acrylate compounds of this invention may be obtained e.g. by a five-step one-pot synthesis in which reactants are added sequentially in the same reaction vessel, as follows (the Formulae illustrate specific exemplified reactants):

<u>FIRST STEP</u>

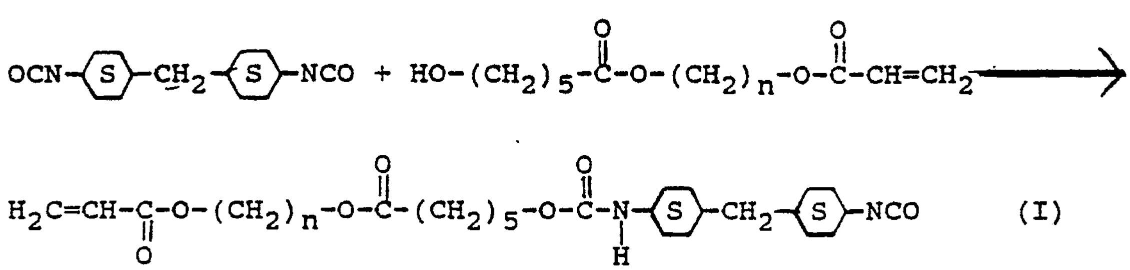

(I)

This first step involves reacting one mole of a suitable diisocyanate with one mole of a suitable hydroxyalkyl or extended-alkyl acrylate to form the corresponding isocyanate capped acrylate (I).

Suitable diisocyanates for use in this step include are aliphatic, cycloaliphatic aromatic and aromatic-aliphatic diisocyanates, e.g. dicyclohexylmethylene diisocyanate, isophorone diisocyanate, hexamethylene diisocyanate, trimethylhexamethylene diisocyanate, toluene, and phenyl diisopropylene diisocyanates.

Suitable hydroxyalkyl acrylate compounds include hydroxymethyl acrylate, hydroxyethyl acrylate, hydroxypropyl acrylate, hydroxybutyl acrylate and the like. Suitable alkyl chain extender compounds include compounds derived from the reaction products of hydroxyalkyl acrylates and caprolactone, caprolactam, or an epoxide, and the like. A preferred reaction product is available commercially as "Tone M-100," from Union Carbide Corp., which is a caprolactone acrylate monomer. (For purposes of this specification, the term "acrylate"includes the corresponding methacrylate derivative).

SECOND STEP

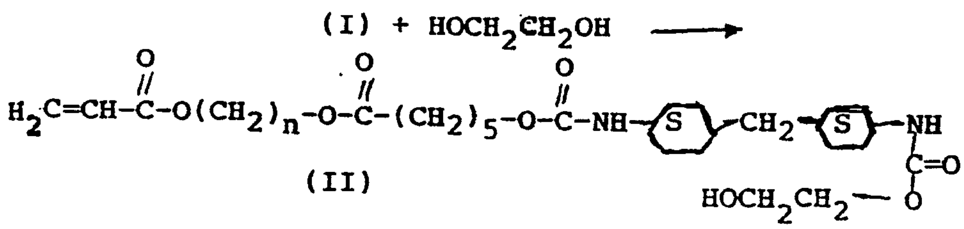
(I) (II)

In this second step, one mole of a polyol is reacted with the remaining isocyanate group of compound (I). Suitable polyols include diols, triols, tetraols and pentols, which may be simple polyols, or poly(polyols). Representative compounds include alkylene polyols, saturated unsaturated, e.g. ethylene glycol, propylene glycol and polybutadiene glycol; polyether polyols; polyester polyols; caprolactonepolyols; polyurethane polyols; bis-phenol A; 1,4-butanediol; and the like.

THIRD STEP

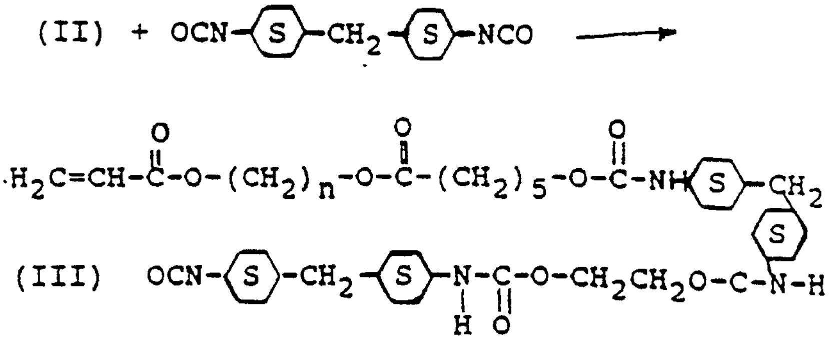
(II) (III)

In this third step, a second mole of diisocyanate is reacted with the free hydroxyl group of compound (II).

FOURTH STEP

(III) +

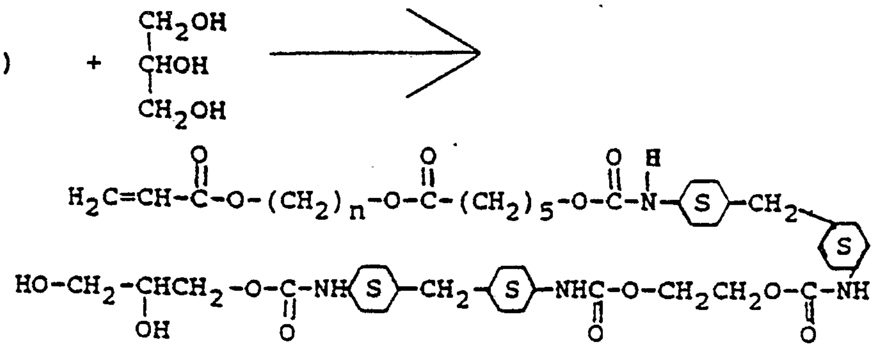

(IV)

In this fourth step, one mole of a simple alkylene polyol compound is added to the intermediate (III) to hydroxyalkylene endcap the remaining of the diisocyanate.

Suitable alkylene polyols have 3-6 hydroxyl groups and 3-6 carbon atoms. Preferred compounds are glycerol, trimethylolpropane, 1,2,6-hexanetriol, pentaerythritol, L-arabinose, dipentaerythritol and sorbitol. Glycerol is most preferred.

FIFTH STEP

(IV) +

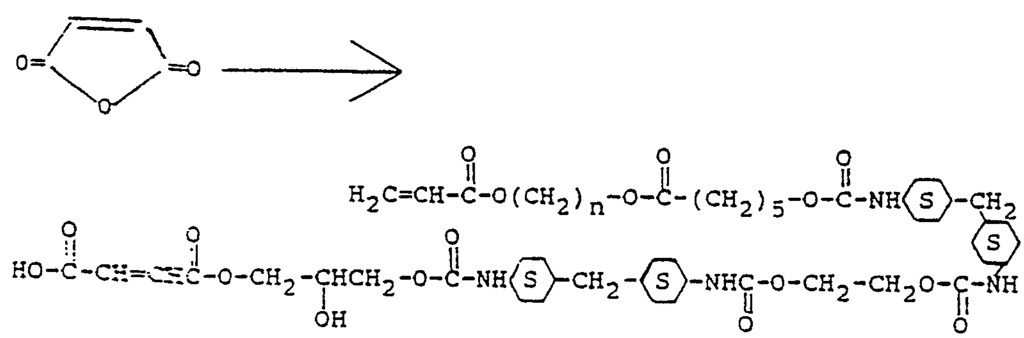

(V)

In the final step of this synthesis of the urethane acrylate compounds,at least one-half mole of a dicarboxylic acid or anhydride is added to form the desired terminal acid group in the molecule. Preferably about one mole is used.

Dicarboxylic acid anhydrides are preferred for this step because they react faster than the corresponding acids. Suitable acid anhydrides include maleic, succinic, glutaric, adipic and phthalic anhydrides. Maleic anhydride is a preferred acid anhydride, in an amount of at least one half mole per mole of polyol used in Step Four.

SOLDER MASK FORMULATION

A. Composition

100% solids, solvent-free UV curable, aqueous alkaline developable urethane acrylate compositions for forming a solder mask, embodying the invention generally comprise:

a. 20-60%, preferably 15-30%, by weight of the urethane acrylate compound described above;

b. 10 40%, preferably 15-35%, by weight of an aromatic urethane diacrylate;

c. 10-30%, preferably 10-20%, by weight of an aliphatic or cycloaliphatic urethane diacrylate, or mixtures thereof;

d. 10-40%, preferably 15-30%, by weight of one or more reactive monomer diluents; and

e. 0.5-10%, preferably 1-3% by weight of a photoinitiator.

The above components may be obtained e.g. as follows:

a. As described above and examples which follow.

b. Reaction of aromatic diisocyanate and hydroxyalkyl acrylate.

c. Photomer 6008 (Diamond Shamrock) or SR-9503 (Sartomar Co.) (as 100% reactive materials), for example.

d. The reactive diluent monomers may be included in the compositions described to reduce their viscosity and further increase their curing rate. Suitable reactive diluent monomers for use therein include ethylenically unsaturated monomers that are compatible and copolymerizable with the urethane acrylate and urethane diacrylates used. Such ethylenically unsaturated monomers include mono-, di- and triacrylates as, for example, hydroxyalkyl acrylates, such as e.g. hydroxyethyl acrylate; and acrylate esters, e.g. methyl methacrylate, ethyl acrylate, 2-ethylhexyl acrylate, cyclohexyl acrylate, isobutoxymethyl methacrylate, t-butyl acrylate, methyl acrylate, butyl acrylate, 2-(N-ethylcarbamyl) ethyl methacrylate; aryloxyalkyl acrylates, e.g. phenoxyethyl acrylate; bis-phenol A diacrylate, ethylene glycol diacrylate, polyethylene glycol diacrylate, glycerol diacrylate and methacrylate, bis-phenol A diacrylate, tetrapropylene glycol diacrylate, and the like. Suitable triacrylates include glycerol tri-acrylate, ethoxylated trimethylol propane triacrylate, and the like.

Other reactive compounds can be included in d. to increase the cross-linking density of the coating. Such reactive compounds include, but are not limited to, pentaerythritol 3-mercaptopropionate, 1,4-butylene dimethacrylate or acrylate,1,1,6-6- tetrahydroperfluorohexanediol diacrylate, ethylene dimethacrylate, glycerol diacrylate or methacrylate, glycerol trimethacrylate, diallyl phthalate and 1,3,5-tris (2-methacryloxyethyl) triazine.

e. The UV curable composition described generally also contains a photoinitiator which generates free radicals owing to actinic light. Suitable examples of such photoinitiators include substituted and unsubstituted polynuclear quinones, such as 2-ethylanthraquinone, 2-t-butylanthraquinone, octamethylanthraquinone, 1,2-benzanthraquinone, 2,3-diphenylanthraquinone, thioxanthone, e.g. chloro and isopropyl derivates, and the like; ketoaldonyl compounds such as diacetyl, benzyl and the like; α-ketoaldonyl alcohols and ethers, such as benzoin, pivalone, and the like; α-hydroxycarbon-substituted aromatic acyloins such as benzophenone, 4,4′-bisdialkylaminobenzophenone, and the like. These photoinitiators may be used alone or as a combination of two or more of them. Examples of combinations include 2,4,5 triarylimidazole dimer and 2-mercaptobenzoquinazole, leucocrystal violet, tris (4-diethylamino-2-methylphenyl) methane, or the like and compounds which may not have photoinitiating properties alone but which nevertheless can constitute a good photoinitiating system, in combination with the above-mentioned materials. Such compounds include, for example, tertiary amines, such as triethanolamine and the like, which are used in combination with benzophenone.

f. Optional components:

The composition preferably includes other components of a commercial composition such as a cross-linker, e.g. hexaalkoxymelamine; a flame retardant, such as a mixture of a brominated compound and antimony trioxide or pentoxide; a rheology modifier; a pigment dispersion aid; and a cure rate enhancer, such as triphenylphosphite, in amounts of about 0.1-15% by weight of each.

Compounds, compositions and solder mask techniques embodying the invention are now described by way of example.

## Example 1

Five-Step, One-Pot Synthesis of Urethane Acrylate Reaction Product of Tone-100/Desmodur-W/Ethylene Glycol/Desmodur-W/Glycerol/Maleic Anhydride

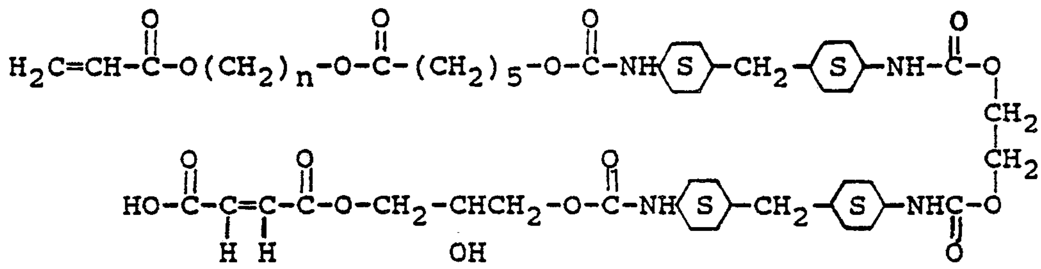

where n=1-8.

| | REACTANT | PARTS | EQUIVALENTS | MOLES |
|---|---|---|---|---|
| A. | 4,4′-dicyclohexylmethylene diisocyanate | 524 | 4 | 2 |
| B. | Dibutyltin dilaurate | 3.2 | 2000 ppm | |
| C. | Tone M-100 (Union Carbide) (Hydroxyalkyl acrylate of caprolactone-MW/344) | 344 | 1 | 1 |
| D. | Hexanediol diacrylate | 480 | | |
| E. | Ethylene glycol | 62 | 2 | 1 |
| F. | Glycerol | 92 | 3 | 1 |
| G. | Maleic anhydride | 98 | 1 | 1 |
| H. | Hydroquinone methyl ether | 3.2 | 2000 ppm | |

A 3-liter dry resin kettle equipped with a mechanical stirrer, thermometer, drying tube and pressure equalizing dropping funnel was charged with 2 equivalents of (A), (D) and 1000 ppm of (B). The mixture was stirred while (C) was added slowly through the dropping funnel over 30 min. The temperature of the reaction mixture was maintained at below 50 °C. After the addition of (C) was completed the mixture was maintained at 60 °C for 2 hrs, or until the NCO number 4.1 ± 0.2. The temperature of the mixture then was lowered to 40 °C and 1000 ppm of (B) was added followed by dropwise addition of 2 equivalents of (A) over 30 min. The temperature was lowered to 40 °C and (F) was added over 15 min. The NCO number was 3.3 ± 0.2. The temperature was maintained at 50 °C until infrared spectroscopy showed the absence of NCO absorption at 2275 $cm^{-1}$ (G) then was added to the reaction mixture at 70-75 °C over 20 min. followed by (H). Heating was continued at 85-90 °C until IR showed the absence of peaks at 1845 and 1975 $cm^{-1}$.

The product was a viscous liquid which was diluted in 30 wt.% hexanediol diacrylate, having a viscosity of 500,000 cps at 25 °C; the acid number was 42 (0.75 meq/gm).

## Example 2

Five-Step, One-pot Synthesis of Urethane Acrylate: Tone-100/TMXDI /EG/TMXDI/Glycerol/Maleic Anhydride

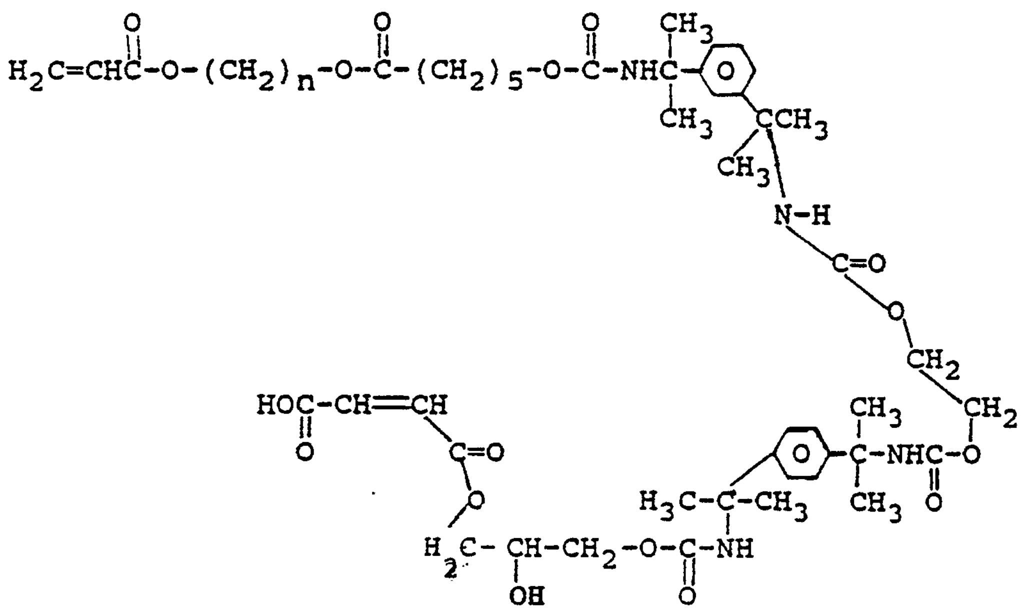

where n=1-8.

| | REACTANT | PARTS | M.W. |
|---|---|---|---|
| A. | Phenyl diisopropylene diisocyanate (TMXDI (Amer. Cyanamid)) | 244.3 | 244.3 |
| B. | Tone-100 | 172 | 344 |
| C. | Ethylene glycol (EG) | 31 | 62 |
| D. | Glycerol | 46 | 92 |
| E. | Maleic anhydride (MA) | 49 | 98 |
| F. | Dibutyltin dilaurate (T-12) | 3 | |
| G. | Hydroxyquinone monomethylether (MEHQ) | 3 | |
| H. | Hexanediol diacrylate (HDODA) | 232.3 | |

A 3-liter dry resin kettle equipped with a mechanical stirrer, thermometer,drying tube and a pressure

equalizing dropping funnel was charged with 122.2 gm TMXD1, 232.3gm HDODA (as diluent).

The mixture was stirred while 172 g. of Tone-100 was added slowly through the dropping funnel over 30 min. The temperature of the mixture was maintained below 50 °C. After the addition of Tone-100 was completed, the mixture was maintained at 60 °C for 2 hrs or until the NCO no. was 3.8. ± 0.2 The temperature of the mixture was lowered to 40 °C and 1 g. T-12 was added, followed by ethylene glycol, both slowly over 15 min. The temperature was maintained at below 55 ° C, during the addition, and at 60 °C for another 3 hours after the addition, and until IR showed no NCO absorption at 2275 $cm^{-1}$. The temperature of the mixture then was lowered to 40 °C and 1 gm T-12 as added followed by dropwise addition of TMXD1 over 30 min. The mixture was maintained at 60 °C until the NCO number was 2.9 ± 0.2. The temperature of the mixture then was lowered to 40 °C and 1 g of T-12 was added followed by 46 g. of glycerol over 15 min. After the addition, the temperature was maintained at 60 C until IR showed the absence of NCO absorption at 2275 $cm^{-1}$. MA then was added to the reaction mixture at 70-75 °C over 20 min., followed by MEHQ. Heating was continued at 85-90 ° C for 5 hrs or until IR showed the absence of 1845 and 1975 $cm^{-1}$ peaks.

The product had an acid no. of 47 (0.84 meq/gm) and a viscosity of 240,000 cps at 23 °C.

## Example 3

Example 1 was repeated using, successively, sorbitol, trimethylolpropane, 1,2,6-hexanetriol and pentaerythritol in place of glycerol to provide the corresponding urethane acrylate derivatives.

## Example 4

### Preparation of Aromatic Urethane Diacrylate

Toluene diisocyanate (1 mole) and hydroxypropyl acrylate (2 moles) were reacted at 55 °C. for 6 hrs. to give the desired product, which was a viscous liquid having a Brookfield viscosity of 68,000 cps at 50 °C.

## Example 5

### Solder Mask Composition

The following composition was prepared using the resin product of Example 1, and was used in forming a solder mast coating on a printed circuit board.

| Composition | |
|---|---|
| Component | Parts by Weight |
| Urethane acrylate of Ex.1 | 28 |
| Photomer 6008 (Diamond Shamrock) Aliphatic urethane diacrylate | 12 |
| Aromatic urethane diacrylate of Ex. 4 | 21 |
| Reactive monomer diluents | |
| Trimethylolpropane triethoxy triacrylate | 15 |
| Hexanediol diacrylate | 12 |
| Tripropyleneglycol diacrylate | 5 |
| Irgacure 651 - photoinitiator | 1 |
| Cymel 300 - cross-linker | 8 |
| Optional | |
| Triphenyl phosphite | 1 |
| Colloid 640 - leveling aid | 2 |
| Flame retardant additives-Brominated flame retardants and antimony trioxide | 5 |
| Pigment - Phthalocyanine green | 0.2 |

## Example 6

## Solder Mask on Printed Circuit Board

A copper-clad epoxy fiber glass printed circuit board was cleaned by scrubbing to remove corrosion and foreign material and coated by screen printing with the composition of Example 4 to a thickness of about 3 mils. Thereafter another 3 mil thick coating was applied onto a phototool in accordance with the method given in U.S. 4,506,004, Example 2. The coating on the phototool was then given a partial flash hardening using a mercury vapor lamp with 0.05-0.1 joules per $cm^2$ of energy, mated with the liquid solder mask on the printed circuit board to form a composite coating of 6 mils thickness, flipped over and given a main exposure with 0.2-0.4 joules per $cm^2$ for 15-30 seconds. The coating was then developed by removing the unexposed portions (negative working) in a 1% sodium carbonate solution (pH 11) at room temperature for 4 min., baked at 150° C. for 1 hr., and finally cured with 1-2.5 joules per $cm^2$ of UV energy.

The cured solder mask was a smooth, uniform, glossy, and flexible coating having 100% adhesion under a cross-hatch tape test both before and after application of solder; resistant to organic solvents for more than 15 minutes in an immersion test; exhibited excellent legend ink adhesion characteristics; excellent heat resistance as measured by a 20 second dip in solder at a temperature of 285° C. without blistering; surface pencil hardness of greater than H, and very good abrasion resistance; excellent adhesion to the printed circuit board, and an electrical insulation resistance which exceeds Class III (IPC-SM-840A) requirements of $5 \times 10^8$ ohm-cm. after 7 days at 25-65° C. cycling at 95% R.H.

Although the invention has been described with particular reference to certain specific embodiments thereof, it will be understood that modifications and changes may be made which are within the skill of the art.

## Claims

1. A liquid urethane acrylate oligomer comprising the reaction product of two moles of an aliphatic,cycloaliphatic, aromatic, or aromatic-aliphatic diisocyanate, or mixture thereof, one mole of a first polyol, one mole of a second,alkylene, polyol having 3-6 hydroxyl groups and 3-6 carbon atoms, and at least one-half mole of a dicarboxylic acid or anhydride per mole of the second polyol.

2. An oligomer according to claim 1 , wherein the diisocyanate is dicyclohexylmethylene diisocyanate, isophorone diisocyanate, hexamethylene diisocyanate, toluene diisocyanate or phenyl diisopropylene diisocyanate.

3. An oligomer according to claim 1 or claim 2 wherein the first polyol is diol, triol, tetraol or pentaol.

4. An oligomer according to any one of claims 1 to 3 wherein the first polyol is an alkylene polyol, saturated or unsaturated, a polyether, polyester caprolactone or polyurethane polyol.

5. An oligomer according to any one of the preceding claims wherein the second alkylene polyol is glycerol, trimethylolpropane, 1,2,6-hexanetriol, pentaerythritol, L-arabinose, dipentaerythritol or sorbitol.

6. An oligomer according to any one of the preceding claims in which the hydroxy extended-alkyl acrylate monomer is the reaction product of a hydroxyalkyl acrylate and caprolactone caprolactam or an epoxide.

7. An oligomer according to any one of the preceding claims in which the dicarboxylic acid or anhydride is unsaturated.

8. An oligomer according to any one of the preceding claims obtained with one mole of dicarboxylic acid or anhydride per mole of the second polyol.

9. An oligomer having the formula:

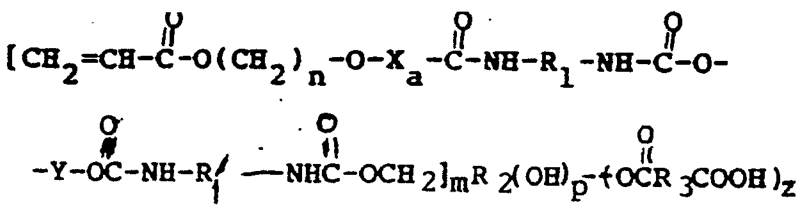

where:
n is 1-8;
X is derived from a caprolactone, cap olactam or epoxide;
a is 0 or, 1;
$R_1$ and $R'_1$ are independently aliphatic, cycloal aromatic or aromatic-aliphatic;
Y is the residue of a polyol with two hydroxyl groups removed;
m is 1-3;
$R_2$ is alkylene $C_1$-$C_6$, provided that if $m = 1$, then $R_2$ is alkylene $C_2$-$C_6$;
p is 0-4;
$R_3$ is aliphatic or cycloaliphatic, saturated or unsaturated, or aromatic, and
z is 1-3.

10. An oligomer according to claim 9 wherein n is 2-3;
X is $\{\overset{O}{\overset{||}{C}}(CH_2)_5-O\}_b$ where b is 1-10;
$\{\overset{O}{\overset{||}{C}}(CH_2)-NH\}_c$ where c is 1-10; or

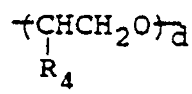

where d is 2-20, and $R_4$ is H, alkyl or cycloalkyl with from one to six carbon atoms;
$R_1$ and $R_2'$ are selected from dicyclohexylmethylene and phenyl diisopropylene;
m is 1 or 2;
Y is alkylene;
$R_2$ is derived from glycerol;
$R_3$ is derived from maleic anhydride;
p is 0 or 1;
z is 1; and
$3 \leq m + p + z \leq 6$.

11. A urethane acrylate oligomer having:
(a) terminal ethylenic unsaturation;
(b) at least one terminal carboxylic acid group;

(c) two intermediate urethane groups;

(d) a polyol residue connecting the urethane groups; and

(e) a simple alkylene group derived from a simple alkylene polyol connecting one of the urethane groups with the terminal carboxylic acid group.

12. A composition comprising:

(a) 20-60% by weight of a urethane acrylate oligomer of any one of the preceding claims;

(b) 10-40% by weight of an aromatic urethane diacrylate;

(c) 10-30% by weight of an aliphatic or cycloaliphatic urethane diacrylate; or mixtures thereof;

(d) 10-40% by weight of one or more reactive monomer diluents; and

(e) 0.5-10% by weight of a photoinitiator.

13. A composition according to claim 12 wherein (a) is 30%; (b) is 10-30%; and (c) is 5-20%, by weight.

14. A composition according to claim 12 or claim 13 in which reactive monomer diluent (d) includes a mono-di- and/or tri-acrylate.

15. A composition according to claim 14 in which diluent (d)includes a hydroxyalkyl acrylate, or an aryloxyalkyl acrylate.

16. A solder mask composition comprising a urethane acrylate oligomer according to any one of claims 1 to 11.

17. Use as a solder mask of a composition according to any one of claims 12 to 16.

18. A method of forming a solder mask which comprises the steps of:

(a) applying a coating of a composition according to any one of claims 12 to 16 to a printed circuit board;

(b) Curing the coating by exposure to UV radiation, and,

(c) developing the coating with an aqueous alkaline solution.

19. The solder mask product obtainable by curing a composition according to any one of claims 12 to 16.